# EUROPÄISCHE PATENTSCHRIFT

(11) **EP 2 286 644 B1**
(45) Veröffentlichungstag und Bekanntmachung des Hinweises auf die Patenterteilung: **26.09.2012**
(21) Anmeldenummer: 09753314.5
(22) Anmeldetag: 29.05.2009
(51) Int. Cl.: H05K 1/18, H01L 23/538

(54) **VERFAHREN ZUR INTEGRATION WENIGSTENS EINES ELEKTRONISCHEN BAUTEILS IN EINE LEITERPLATTE SOWIE LEITERPLATTE**
METHOD FOR INTEGRATING AT LEAST ONE ELECTRONIC COMPONENT INTO A PRINTED CIRCUIT BOARD, AND PRINTED CIRCUIT BOARD
PROCÉDÉ POUR INTÉGRER AU MOINS UN COMPOSANT ÉLECTRONIQUE DANS UN CIRCUIT IMPRIMÉ ET CIRCUIT IMPRIMÉ

(30) Priorität: 30.05.2008 AT 3132008 U
(43) Veröffentlichungstag der Anmeldung: 23.02.2011
(73) Patentinhaber: AT & S Austria Technologie & Systemtechnik Aktiengesellschaft, 8700 Leoben-Hinterberg (AT)
(72) Erfinder: WEICHSLBERGER, Günther, A-8044 Graz (AT); KRIECHBAUM, Arno, A-8700 Leoben (AT); MORIANZ, Mike, A-8045 Graz (AT); HASLEBNER, Nikolai, A-8740 Zeltweg (AT); STAHR, Johannes, A-8600 Bruck (AT); HARING, Fritz, A-8600 Bruck (AT); FREYDL, Gerhard, A-8700 Leoben (AT); KOERTVELYESSY, Andrea, A-1030 Wien (AT); BEESLEY, Mark, A-8700 Leoben (AT); ZLUC, Andreas, A-6972 Fussach (AT); SCHRITTWIESER, Wolfgang, A-8605 Kapfenberg (AT)
(74) Vertreter: Miksovsky, Alexander
(86) Internationale Anmeldenummer: PCT/AT2009/000224
(87) Internationale Veröffentlichungsnummer: WO 2009/143550

(56) Entgegenhaltungen:
- WO-A1-2007/087660
- US-A1- 2005 112 798

## Beschreibung

Die vorliegende Erfindung bezieht sich auf ein Verfahren zur Integration wenigstens eines elektronischen Bauteils in eine Leiterplatte, umfassend die folgenden Schritte:
- Bereitstellen einer Schicht einer Leiterplatte zur Abstützung des elektronischen Bauteils,
- Aufbringen eines Klebers auf eine Oberfläche der Schicht,
- Festlegen des elektronischen Bauteils auf der Schicht mittels des Klebers,
- Aufbringen bzw. Anordnen wenigstens einer elektrisch leitenden Schicht auf bzw. an dem Bauteil an der vom Kleber abgewandten Seite bzw. Oberfläche, und
- Strukturieren der elektrisch leitenden Schicht entsprechend den Kontakten des elektronischen Bauteils und/oder entsprechend auf der Leiterplatte auszubildenden Leiterbahnen.

Die Erfindung bezieht sich weiters auf eine Leiterplatte mit wenigstens einem integrierten, elektronischen Bauteil, umfassend eine Schicht zur Abstützung des elektronischen Bauteils, an welcher der wenigstens eine elektronische Bauteil unter Vermittlung eines Klebers festgelegt ist, wobei wenigstens eine elektrisch leitende Schicht nach Festlegung des elektronischen Bauteils auf bzw. an dem Bauteil angeordnet ist und entsprechend den Kontakten des elektronischen Bauteils und/oder Leiterbahnen der Leiterplatte strukturiert ist.

Im Zusammenhang mit wachsenden Produktfunktionalitäten von mit elektronischen Bauteilen versehenen Geräten und einer zunehmenden Miniaturisierung derartiger elektronischer Bauteile sowie einer zunehmenden Anzahl elektronischer Bauteile, mit welchen Leiterplatten zu bestücken sind, werden zunehmend leistungsfählge feld- bzw. arrayförmig aufgebaute Bauteile bzw. Packages mit mehreren elektronischen Komponenten eingesetzt, die eine Vielzahl von Kontakten bzw. Anschlüssen bei zunehmend verringertem Abstand dieser Kontakte aufweisen. Zur Festlegung bzw. Kontaktierung derartiger Bauteile wird zunehmend der Einsatz von stark entflochtenen Leiterplatten erforderlich, wobei davon auszugehen ist, daß bei einer gleichzeitigen Verringerung der Produktgröße sowie der einzusetzenden Bauteile und Leiterplatten sowohl hinsichtlich der Dicke als auch der Fläche derartiger Elemente zu erwarten ist, daß eine Bestückung bzw. Anordnung derartiger elektronischer Bauteile über die erforderliche Vielzahl von Kontaktstellen an Leiterplatten problematisch wird bzw. an Grenzen der mögllchen Auflösung derartiger Kontaktstellen gelangt.

Zur Lösung derartiger Probleme wurde zwischenzeitlich vorgeschlagen, elektronische Bauteile wenigstens teilweise in eine Leiterplatte zu integrieren, wobei beispielsweise auf die WO 03/065778, die WO 03/065779 oder die WO 2004/077902 verwiesen wird. Bei diesen bekannten Verfahren bzw. Ausführungsformen von in einer Leiterplatte integrierten, elektronischen Bauteilen bzw. Komponenten ist jedoch nachteilig, daß für die Aufnahme derartiger elektronischer Bauteile bzw. Komponenten jeweils Ausnehmungen bzw. Löcher in einem Grundelement einer Leiterplatte vorzusehen sind, wobei darüber hinaus vor Anordnung eines Bauteils in einem derartigen Loch Leiterbahnen ausgebildet werden. Für eine Kontaktierung der Bauteile werden Lötprozesse und Bondtechniken eingesetzt, wobei üblicherweise Kontaktstellen zwischen Materialien unterschiedlichen Typs zwischen Elementen der Leiterbahnen als auch den Kontakt- bzw. Anschlußstellen der elektronischen Bauteile resultieren. Vor allem bei einem Einsatz derartiger Systeme in Umgebungen mit großem Temperaturunterschied bzw. Temperaturwechselbereichen ergeben sich durch den Einsatz unterschiedlicher Materialien im Bereich der Kontakt- bzw. Anschlußstellen unter Berücksichtigung der unterschiedlichen thermischen Ausdehnungskoeffizienten mechanisch bzw. thermisch induzierte Spannungen, welche zum Riß wenigstens einer Kontakt- bzw. Anschlußstelle und somit zum Versagen des Bauteils führen können. Darüber hinaus ist davon auszugehen, daß zusätzlich erforderliche Bohrungen, insbesondere Laserbohrungen, zur Herstellung von Kontaktflächen die Komponenten belasten. Weiters ist nachteilig, daß eine Kontaktierung der in den herzustellenden Ausnehmungen bzw. Vertiefungen eingebetteten Bauteile an Leiterbahnen und Kontaklflächen durch Lötpasten oder Bonddrähte erschwert wird bzw. insbesondere bei einem Einsatz mit schwankenden Temperaturbelastungen nicht zuverlässig erzielbar ist. Ergänzend ist nachteilig, daß gegebenenfalls vorzusehende, hohe Drücke und Temperaturen während des Leiterplatten-Herstellungsprozesses die eingebetteten und kontaktierten Komponenten belasten. Weiters ist eine Wärmeableitung von gegebenenfalls stärker belasteten, elektronischen Bauteilen problematisch.

Ein Verfahren und eine Leiterplatte der eingangs genannten Art sind beispielsweise der WO 2007/087660 A1 oder der US 2005/0112798 A1 zu entnehmen, wobei einerseits insbesondere auf eine Verbesserung einer Klebebefestigung einer Komponente bzw. eines Bauteils und andererseits auf eine Einbettung einer Komponente insbesondere unter Vermeidung von Freiräumen um die Komponente abgezielt wird.

Die vorliegende Erfindung zielt somit darauf ab, die obengenannten Probleme bei einer Integration wenigstens eines elektronischen Bauteils in eine Leiterplatte zu beheben bzw, zumindest stark zu reduzieren, und zielt insbesondere darauf ab, ein Verfahren der eingangs genannten Art sowie eine Leiterplatte zur Verfügung zu stellen, bei welchen bei vereinfachtem Verfahrensablauf eine Verbesserung der Zuverlässigkeit der Anordnung bzw. Festlegung und Kontaktierung wenigstens eines elektronischen Bauteils in einer Leiterplatte und eine Verbesserung einer Wärmeableitung erzielbar ist.

Zur Lösung dieser Aufgaben ist ein Verfahren zur Integration wenigstens eines elektronischen Bauteils in eine Leiterplatte der eingangs genannten Art im wesentlichen dadurch gekennzeichnet, daß an der von der elektrisch leitenden Schicht abgewandten Seite des elektronischen Bauteils insbesondere im Bereich der Festlegung des elektronischen Bauteils wenigstens eine Öffnung zur Wärmeableitung und/oder Kontaktierung des Bauteils ausgebildet wird.

Es ist ein Aufbringen und Festlegen des wenigstens einen elektronischen Bauteils auf einer Schicht einer Leiterplatte zur Abstützung des elektronischen Bauteils vorgesehen, wobei im Gegensatz zu dem eingangs genannten Stand der Technik auf eine vorhergehende Ausbildung von Vertiefungen bzw. Ausnehmungen zur Aufnahme des elektronischen Bauteils als auch auf eine vorhergehende Ausbildung von Kontaktstellen oder Leiterbahnen, welche entsprechend den Kontakten des aufzunehmenden, elektronischen Bauteils angeordnet werden müssen, verzichtet werden kann. Es erfolgt somit eine starke Vereinfachung im Zusammenhang mit der Anordnung und Positionierung des wenigstens einen elektronischen Bauteils, welcher in die Leiterplatte zu integrieren ist, so daß auf aufwendige Positionierschritte oder Vorbereitungsschritte zur Herstellung einer Aufnahmeöffnung für den elektronischen Bauteil verzichtet werden kann. Nach erfolgter Anordnung und Festlegung des elektronischen Bauteils auf der Schicht zur Abstützung des elektronischen Bauteils erfolgt in weiterer Folge eine Aufbringung bzw. Anordnung wenigstens einer elektrisch leitenden Schicht auf bzw. an dem Bauteil an der vom Kleber abgewandten Seite bzw. Oberfläche, welche die Kontakte bzw. Anschlußstellen des zu integrierenden, elektronischen Bauteils aufweist, worauf nachfolgend eine Strukturierung dieser elektrisch leitenden Schicht entsprechend den Kontakten des elektronischen Bauteils sowie einer Verbindung mit diesen und/oder entsprechend auf der Leiterplatte auszubildenden Leiterbahnen erfolgt. Eine derartige Ausbildung bzw. Strukturierung der elektrisch leitenden Schicht nach einer Anordnung und Festlegung des Bauteils erleichtert hiebel die für eine ordnungsgemäße Kontaktierung erforderlichen, präzisen Verfahrensschritte, da die erforderliche Kontaktierungen und/oder Leiterbahnen abgestimmt auf die Positionierung des bereits festgelegten, elektronischen Bauteils erfolgen bzw. ausgebildet werden können. Darüber hinaus kann durch die Aufbringung bzw. Anordnung der elektrisch leitenden Schicht auf bzw. an dem Bauteil, womit auch eine Kontaktierung mit den Kontaktstellen des elektronischen Bauteils verbunden ist, auf aufwendige und unter Berücksichtigung der zunehmend geringer werdenden Abstände derartiger Kontakte bzw. Anschlußstellen des elektronischen Bauteils schwieriger werdende Verfahren einer Kontaktierung, wie beispielsweise durch Einsatz eines Löt- oder Galvanik- oder Bondprozesses weitestgehend verzichtet werden bzw. können derartige Prozesse in vereinfachter Weise nach der Aufbringung bzw. Festlegung der elektrisch leitenden bzw. leitfähigen Schicht und deren Strukturierung vorgenommen werden. Da vorgesehen ist, daß erst nach der Festlegung des wenigstens einen elektronischen Bauteils und Anordnung der elektrisch leitenden bzw. leitfähigen Schicht eine Strukturierung der elektrisch leitenden Schicht der Leiterplatte entsprechend den Kontakten bzw. Anschlußstelle des elektronischen Bauteils und/oder der in der elektrisch leitenden Schicht herzustellenden Leiterbahnen erfolgt, kann im Gegensatz zu bekannten Verfahren bzw. Ausbildungen auf erforderliche, hohe Anforderungen im Hinblick auf eine präzise Positionierung des elektronischen Bauteils relativ zu bereits ausgebildeten Kontaktflächen bzw. Leiterbahnen der Leiterplatte verzichtet werden. Es kann mit einfachen Mitteln die Position des elektronischen Bauteils nach der Festlegung unter Vermittlung des Klebers an der Schicht festgestellt werden, worauf in einfacher Weise und präzise positionierbar die Anordnung und Strukturierung der leitenden Schicht der Leiterplatte vorgenommen wird.

Zusätzlich zu den oben genannten Schritten ist für eine Wärmeableitung von in gegebenenfalls stark beanspruchten, elektronischen Komponenten erzeugter Wärme erfindungsgemäß vorgesehen, daß an der von der elektrisch leitenden Schicht abgewandten Seite des elektronischen Bauteils insbesondere im Bereich der Festlegung des elektronischen Bauteils wenigstens eine Öffnung zur Wärmeableitung und/oder Kontaktierung des Bauteils ausgebildet wird.

Um eine im wesentlichen ebene Auflagefläche für die nach der Festlegung des elektronischen Bauteils aufzubringende bzw. anzuordnende, wenigstens eine elektrisch leitende Schicht zur Verfügung zu stellen und um eine ordnungsgemäße und sichere sowie geschützte Einbettung des wenigstens einen elektronischen Bauteils im Inneren der Leiterplatte sicherzustellen, wird gemäß einer bevorzugten Ausführungsform vorgeschlagen, daß der elektronische Bauteil nach dem Festlegen an der Schicht von einem isolierenden Material, insbesondere einer Prepreg-Folie und/oder einem Harz, umgeben wird.

Da die Schicht der Leiterplatte, welche mit dem in die Leiterplatte zu integrierenden, wenigstens einen elektronischen Bauteil zu verbinden ist bzw. welche die eine Auflage- bzw. Supportoberfläche des zu integrierenden Bauteils darstellt, gegebenenfalls eine äußerst geringe Dicke aufweist, wird gemäß einer weiters bevorzugten Ausführungsform vorgeschlagen, daß die Schicht zur Abstützung des elektronischen Bauteils auf eine Trägerschicht oder einen Kern vor dem Aufbringen des Klebers aufgebracht wird. Eine derartige Trägerschicht stellt eine ausreichend stabile Basis während der Aufbringung des Klebers als auch der nachfolgenden Festlegung des wenigstens einen elektronischen Bauteils zur Verfügung und kann erforderlichenfalls in einfacher Weise vor der nach der Festlegung des elektronischen Bauteils erforderlichen Strukturierung der elektrisch leitenden Schicht wiederum entfernt werden, wie dies einer weiteren bevorzugten Ausführungsform des erfindungsgemäßen Verfahrens entspricht.

Für eine ordnungsgemäße Festlegung des zu integrierenden, wenigstens einen elektronischen Bauteils wird gemäß einer weiters bevorzugten Ausführungsform vorgeschlagen, daß der Kleber auf der Oberfläche der Schicht entsprechend einem auf die Anordnung des festzulegenden, elektronischen Bauteils abgestimmten Muster aufgebracht wird. Derart wird vermieden, daß insbesondere für den weiteren Aufbau der Leiterplatte der Kleber in Bereichen, in welchen eine Festlegung des wenigstens einen elektronischen Bauteils nicht erfolgt, gegebenenfalls aufwendig nachträglich wiederum entfernt werden muß. Der Kleber kann mit an sich bekannten Aufbringungsverfahren, beispielsweise durch ein Siebdrucken, Walzbeschichten, Streichen oder dgl., aufgebracht werden. Ein Kleber kann nach Anordnung bzw. Aufbringung des wenigstens einen zu integrierenden, elektronischen Bauteils gegebenenfalls einer Härtungsbehandlung, beispielsweise durch Anwendung von Wärme und/oder Bestrahlung mit elektromagnetischer Strahlung bestimmter Wellenlänge gehärtet werden. Alternativ kann beispielsweise eine aushärtbare, insbesondere fotoaktive Klebefolie zur Festlegung des zu integrierenden, elektronischen Bauteils vorgesehen sein, welche nach der Anordnung des elektronischen Bauteils beispielsweise einer entsprechenden Aushärtung, insbesondere Fotobearbeitung unterworfen wird.

Wie oben bereits angedeutet, erfolgt gemäß dem erfindungsgemäßen Verfahren eine Strukturierung wenigstens einer elektrisch leitenden Schicht nach einer Festlegung und Kontaktierung des zu integrierenden, wenigstens einen elektronischen Bauteils, wobei in diesem Zusammenhang gemäß einer bevorzugten Ausführungsform vorgeschlagen wird, daß die Strukturierung der leitenden Schicht durch eine Laserstrukturierung, eine Fotostrukturierung oder dgl. durchgeführt wird. Derartige Strukturierungsvorgänge sind an sich bekannt und erlauben eine präzise Ausbildung der Kontaktbereiche sowie der daran anschließenden Leiterbahnen im Bereich der mit dem wenigstens einen elektronischen Bauteil verbundenen bzw. zu verbindenden, elektrisch leitenden bzw. leitfählgen Schicht.

Wie oben bereits angedeutet, ist bei bekannten Ausbildungen bzw. Verfahren zur Integration wenigstens eines elektronischen Bauteils in eine Leiterplatte davon auszugehen, daß die Leiterplatte und insbesondere Leiterbahnen definierende Schichten weitestgehend fertiggestellt sind, wonach der wenigstens eine elektronische Bauteil in einer entsprechenden Vertiefung bzw. Ausnehmung angeordnet und nachfolgend aufwendig kontaktiert wird. Im Gegensatz dazu erfolgt erfingdungsgemäß nach der Festlegung des wenigstens einen elektronischen Bauteils anschließend ein weiterer Aufbau bzw. eine Fertigstellung der Leiterplatte, wobei nach der Strukturierung der elektrisch leitenden Schicht nach dem Festlegen des wenigstens einen elektronischen Bauteils gemäß einer weiters bevorzugten Ausführungsform des erfindungsgemäßen Verfahrens vorgeschlagen wird, daß nach einem Strukturieren der leitenden Schicht wenigstens eine isolierende Schicht auf der von dem elektronischen Bauteil abgewandten Oberfläche der strukturierten, leitenden Schicht aufgebracht wird.

Im Zusammenhang mit der Fertigstellung der Leiterplatte, in welcher wenigstens ein elektronischer Bauteil gemäß dem erfindungsgemäßen Verfahren integriert ist, wird darüber hinaus vorgeschlagen, daß zusätzlich wenigstens eine leitende und/oder nicht leitende Schicht, beispielsweise eine RCC-Folie, aufgebracht bzw. angeordnet wird, wie dies einer weiters bevorzugten Ausführungsform des erfindungsgemäßen Verfahrens entspricht. Derartige RCC-Folien (Resin Coated Copper Foil) sind an sich bekannt und können nach der ordnungsgemäßen Kontaktierung des wenigstens einen elektronischen Bauteils mit der elektrisch leitenden Schicht zur weiteren Fertigstellung der Leiterplatte eingesetzt werden bzw. werden unmittelbar im Zusammenhang mit der Anordnung und Festlegung der elektrisch leitenden Schicht nach Festlegung des elektronischen Bauteils eingesetzt.

Zur weiteren Verbesserung der Wärmeableitung bzw. zur Verteilung der in dem elektronischen Bauteil gegebenenfalls punktuell erzeugten Wärme wird gemäß einer weiters bevorzugten Ausführungsform vorgeschlagen, daß die Schicht zur Abstützung des elektronischen Bauteils von einer metallischen, insbesondere elektrisch leitenden Schicht gebildet wird.

Im Zusammenhang mit einer Unterstützung der Wärmeableitung bzw. Verteilung von gegebenenfalls punktuell auftretenden Stellen einer hohen Wärmebelastung, insbesondere in Teilbereichen des einzubettenden bzw, zu integrierenden, elektronischen Bauteils wird gemäß einer weiters bevorzugten Ausführungsform vorgeschlagen, daß ein thermisch leitender bzw, leitfähiger Kleber verwendet wird.

Zur weiteren Erhöhung der Anzahl der Kontakte bzw. Anschlußstellen eines zu integrierenden, elektronischen Bauteils wird gemäß einer weiters bevorzugten Ausführungsform des erfindungsgemäßen Verfahrens vorgeschlagen, daß ein elektronischer Bauteil verwendet wird, welcher an gegenüberliegenden Hauptoberflächen jeweils mit einer Mehrzahl von Kontakten versehen ist, welche mit den elektrisch leitenden Schichten kontaktiert werden. Durch Verwendung eines elektronischen Bauteils, welcher an gegenüberliegenden Hauptoberflächen jeweils mit einer Mehrzahl von Kontakten versehen ist, kann somit die Zahl der Kontakte bzw. Anschlußstellen erhöht werden, wobei in diesem Zusammenhang bevorzugt, wie dies oben bereits im Zusammenhang mit einer Verbesserung einer Wärmeableitung bzw. Wärmeverteilung vorgeschlagen wurde, auch die den Bauteil abstützende Schicht bzw. Lage, welche mit dem Kleber zur Festlegung des elektronischen Bauteils versehen ist, von einer elektrisch leitenden bzw. leitfähigen Schicht gebildet wird.

Gemäß dem erfindungsgemäßen Verfahren wird darüber hinaus bevorzugt vorgeschlagen, daß unmittelbar nach dem Strukturieren der elektrisch leitenden Schicht der elektronische Bauteil auf seine Funktionsfähigkeit getestet wird. Eine derartige Überprüfung der Funktionsfähigkeit des elektronischen Bauteils unmittelbar nach dem Strukturieren der elektrisch leitenden Schicht nach der Verbindung der Anschlüsse bzw. Kontaktetellen des elektronischen Bauteils mit der elektrisch leitenden Schicht ermöglicht unmittelbar eine Überprüfung bzw. einen Test auch im Hinblick auf die Korrektheit bzw. Vollständigkeit der durchgeführten Kontaktierungen, so daß im Gegensatz zu bekannten Verfahrensführungen bereits zu einem früheren Zeitpunkt die Funktionsfähigkeit bzw. ordnungsgemäße Kontaktierung des wenigstens einen elektronischen Bauteils überprüft werden kann und unter starker Verringerung des Ausschusses bzw. der Kosten bei einer fehlerhaften Kontaktierung bereits zu einem früheren Zeitpunkt während des Verfahrensablaufs schadhafte Elemente ausgesondert werden können.

Zur Lösung der eingangs genannten Aufgaben ist darüber hinaus eine Leiterplatte mit wenigstens einem integrierten, elektronischen Bauteil der eingangs genannten Art im wesentlichen dadurch gekennzeichnet, daß an der von der elektrisch leitenden Schicht abgewandten Seite des elektronischen Bauteils insbesondere im Bereich der Festlegung des elektronischen Bauteils wenigstens eine Öffnung zur Wärmeableitung und/oder Kontaktierung des Bauteils ausgebildet ist. Wie oben bereits angemerkt, läßt sich somit eine einfache und zuverlässige Kontaktierung von Kontakt- bzw. Anschlußstellen des wenigstens einen elektronischen Bauteils mit einer elektrisch leitenden Schicht einer Leiterplatte erzielen, wobei auf aufwendige, zusätzliche Verfahren einer Kontaktierung unter vorhergehender Ausbildung von präzise anzuordnenden Bohrungen bzw. Durchbrechungen verzichtet werden kann. Darüber hinaus ist nach der Festlegung des wenigstens einen elektronischen Bauteils an der Leiterplatte eine einfache und zuverlässige Strukturierung unter Bezugnahme auf den bereits festgelegten, elektronischen Bauteil möglich bzw. erzielbar. Weiters wird eine Wärmeableitung erfindungsgemäß dadurch unterstützt, daß an der von der elektrisch leitenden Schicht abgewandten Seite des elektronischen Bauteils insbesondere im Bereich der Festlegung des elektronischen Bauteils wenigstens eine Öffnung zur Wärmeableitung und/oder Kontaktierung des Bauteils ausgebildet ist.

Für eine zuverlässige Isolierung sowie mechanische Stabilität als auch einen Schutz des zu integrierenden Bauteils ist darüber hinaus bevorzugt vorgesehen, daß der elektronische Bauteil durch ein isolierendes Material, insbesondere eine Prepreg-Folie und/oder ein isolierendes Harz, umgeben ist.

Zur weiteren Fertigstellung der erfindungsgemäßen Leiterplatte ist darüber hinaus vorgesehen, daß zusätzlich eine Mehrzahl von den Bauteil einbettenden Schichten bzw. Lagen aus einem isolierenden und/oder leitenden Material vorgesehen ist, wie dies einer weiters bevorzugten Ausführungsform der erfindungsgemäßen Leiterplatte entspricht.

Zur Ableitung von Wärme von gegebenenfalls höher beanspruchten, elektronischen Bauteilen ist darüber hinaus bevorzugt vorgesehen, daß in dem den elektronischen Bauteil umgebenden, insbesondere isolierenden Material insbesondere im Bereich der Festlegung des elektronischen Bauteils wenigstens eine Öffnung zur Wärmeableitung vorgesehen ist.

Die Erfindung wird nachfolgend anhand von in der beiliegenden Zeichnung schematisch dargestellten Ausführungsbeispielen einer erfindungsgemäßen Leiterplatte unter Einsatz des erfindungsgemäßen Verfahrens näher erläutert. In dieser zeigen:
Fig. 1 eine schematische Darstellung eines ersten Verfahrensschritts des efindungsgemäßen Verfahrens zur Herstellung einer erfindungsgemäßen Leiterplatte, wobei eine Mehrzahl von elektronischen Bauteilen auf einer abstützenden Schicht aufgebracht wird;
Fig. 2 eine schematische Darstellung eines weiteren Verfahrensschritts einer Aufbringung bzw. Anordnung wenigstens einer elektrisch leitenden Schicht;
Fig. 3 eine schematische Darstellung eines Schritts einer Strukturierung der elektrisch leitenden Schicht nach der Aufbringung bzw. Anordnung an dem elektronischen Bauteil;
Fig. 4 eine schematische Darstellung eines weiteren Verfahrensschritts einer Anordnung weiterer Schichten bzw. Lagen einer erfindungsgemäßen Leiterplatte;
Fig. 5 eine schematische Darstellung einer erfindungsgemäßen Leiterplatte nach einer Vornahme einer ergänzenden Strukturierung sowie einer Ausbildung von Wärmeableitöffnungen;
Fig. 6 eine schematische Teildarstellung ähnlich der Darstellung gemäß Fig. 5 unter Einsatz eines zu integrierenden, elektronischen Bauteils, welcher an beiden Hauptflächen mit Kontakten bzw. Anschlußstellen versehen ist;
Fig. 7 in einer Darstellung ähnlich zu Fig. 2 eine schematische Darstellung eines abgewandelten Verfahrensschritts einer Anordnung einer elektrisch leitenden Schicht auf einer Mehrzahl von angeordneten, zu integrierenden, elektronischen Bauteilen;
Fig. 8 eine schematische Darstellung eines weiteren Verfahrensschritts gemäß der abgewandelten Ausführungsform einer Strukturierung von Schichten im Bereich der festgelegten bzw. integrierten, elektronischen Bauteile; und
Fig. 9 eine schematische Darstellung eines weiteren Verfahrensschritts gemäß der abgewandelten Ausführungsform unter Ausbildung von Kontaktierungsstellen.

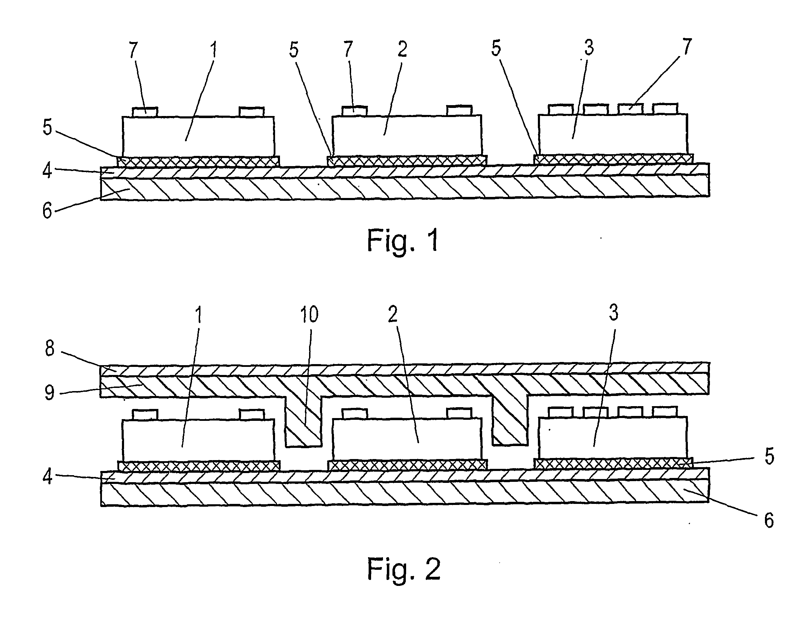

Eine erste Verfahrensführung zur Herstellung einer Leiterplatte zur Integration wenigstens eines elektronischen Bauteils in eine Leiterplatte wird anhand der Fig. 1 bis 5 im Detail erörtert.

Wie in Fig. 1 ersichtlich, wird eine eine Mehrzahl von in eine Leiterplatte zu integrierenden, elektronischen Bauteilen 1, 2 und 3 abstützende Schicht bzw. Lage 4 zur Verfügung gestellt, wobei während der Festlegung der elektronischen Bauteile 1, 2 und 3 über Klebestellen 5 die Lage bzw. Schicht 4 über eine eine vergleichsweise größere Dicke aufweisende Trägerschicht 6 abgestützt wird.

Die zur Festlegung der elektronischen Bauteile 1, 2 und 3 verwendete Klebeschicht 5 wird entsprechend der Anordnung der festzulegenden bzw. in weiterer Folge zu integrierenden Bauteile 1, 2 und 3 auf der Schicht 4 beispielsweise durch ein Siebdrucken, Walzbeschichten oder dgl. aufgebracht. Anstelle eines derartigen Aufbringens einer Klebeschicht in einem Muster entsprechend der Anordnung wenigstens eines elektronischen Bauteils 1, 2 bzw. 3 bzw. der in den Fig. 1 bis 5 dargestellten Bauteile 1, 2 und 3 kann auch die Anordnung bzw. Aufbringung einer Klebefolie 5 vorgesehen sein, welche in weiterer Folge beispielsweise durch ein Fotohärten nach einer Anordnung der festzulegenden, elektronischen Bauteile 1, 2 und 3 aktiviert wird.

Die festzulegenden bzw. zu integrierenden, elektronischen Bauteile 1, 2 und 3 weisen darüber hinaus jeweils eine Mehrzahl von Kontakten 7 auf.

Nach der Festlegung der elektronischen Bauteile 1, 2 und 3 auf der Schicht 4 unter Vermittlung des Klebers 5 wird in weiterer Folge eine elektrisch leitende Schicht 8 auf der vom Kleber 5 abgewandten Seite an den elektronischen Bauteilen 1, 2 und 3 aufgebracht bzw. angeordnet, wobei in der in Fig. 2 dargestellten Ausführungsform die elektrisch leitende Schicht 8 ein Bestandteil einer sogenannten RCC-Folie ist, wobei durch die darüber hinaus vorgesehenen Teilbereiche 9 aus Kunststoff bzw. allgemein isolierendem Material sichergestellt wird, daß nach einer Anordnung der elektrisch leitenden Schicht 8 Freiräume zwischen den einzelnen elektronischen Bauteilen 1, 2 und 3 und/oder im Bereich der Kontaktstellen 7 entsprechend ausgefüllt werden, wobei für Abstände bzw. Freiräume zwischen den einzelnen, festzulegenden, elektronischen Bauteilen 1, 2 und 3 zusätzliche Fortsätze aus isolierendem Material mit 10 angedeutet sind.

Anstelle der in Fig. 2 angedeuteten Verwendung einer RCC-Folie, welche aus der elektrisch leitenden Schicht 8, welche beispielsweise aus Kupfer gebildet ist, und dem isolierenden Material 9 besteht, können auch entsprechend der Anordnung der festzulegenden bzw. zu integrierenden Bauteile 1, 2 und 3 sowie deren Kontakte 7 ein entsprechend gestanztes oder nicht-gestanztes Prepreg und gegebenenfalls getrennte Kupferfolien als elektrisch leitende Schicht 8 eingesetzt werden.

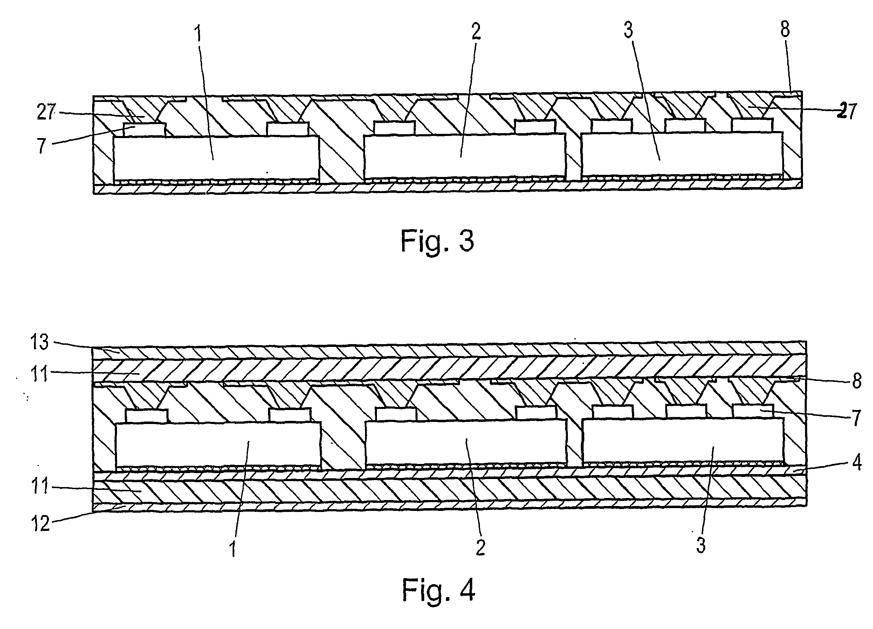

Unmittelbar nach der Aufbringung bzw. Anordnung der elektrisch leitenden Schicht 8 im Bereich der Kontakte bzw. Anschlußstellen 7 der zu integrierenden, elektronischen Bauteile 1, 2 und 3 wird die Trägerschicht 6 entfernt, worauf in weiterer Folge eine Strukturierung der Schicht 4 und der elektrisch leitenden Schicht 8 entsprechend den Kontaktstellen 7 der zu integrierenden Bauteile 1, 2 und 3 als auch beispielsweise durch ein Laserbohren und ein Verfüllen mit einem Kontaktierungsmaterial eine leitende Verbindung zwischen den Kontaktstellen 7 und entsprechenden Teilbereichen der elektrisch leitenden und nunmehr strukturierten Schicht 8 erfolgt, wie dies in Fig. 3 dargestellt und mit 27 angedeutet ist. Im Rahmen der Strukturierung der elektrisch leitenden Schicht 8 werden auch entsprechende Leiterbahnen für die in weiterer Folge herzustellende Leiterplatte ausgebildet bzw. vorgesehen.

Bei der Darstellung gemäß Fig. 4 ist angedeutet, daß nach einer Kontaktierung der zu integrierenden Bauteile 1, 2 und 3, wie dies in Fig. 3 dargestellt ist, für einen weiteren Aufbau der herzustellenden Leiterplatte beispielsweise sowohl anschließend an die die zu integrierenden Bauteile 1, 2 und 3 abstützende Schicht 4 als auch anschließend an die elektrisch leitende Schicht 8 zusätzliche Schichten aufgebracht bzw. vorgesehen werden. Beispielsweise werden jeweils unter Zwischenschaltung eines Prepreg 11, welches beispielsweise eine Dicke von etwa 40 µm aufweist, für einen weiteren Aufbau der Leiterplatte Kupferfolien bzw. Kupferschichten 12 und 13 angeordnet bzw. festgelegt, wobei beispielsweise im Bereich der Unterseite der herzustellenden Leiterplatte eine Kupferfolie 12 mit einer Dicke von weniger als 25 µm, beispielsweise etwa 18 µm, angeordnet wird, während anschließend an die elektrisch leitende Schicht 8 sowie den Prepreg 11 ebenfalls eine Kupferfolie einer ähnlichen Dicke wie an der Unterseite oder eine dicke Kupferfolie 13 mit einer Dicke von mehr als 50 µm, insbesondere beispielsweise 80 µm, angeordnet wird.

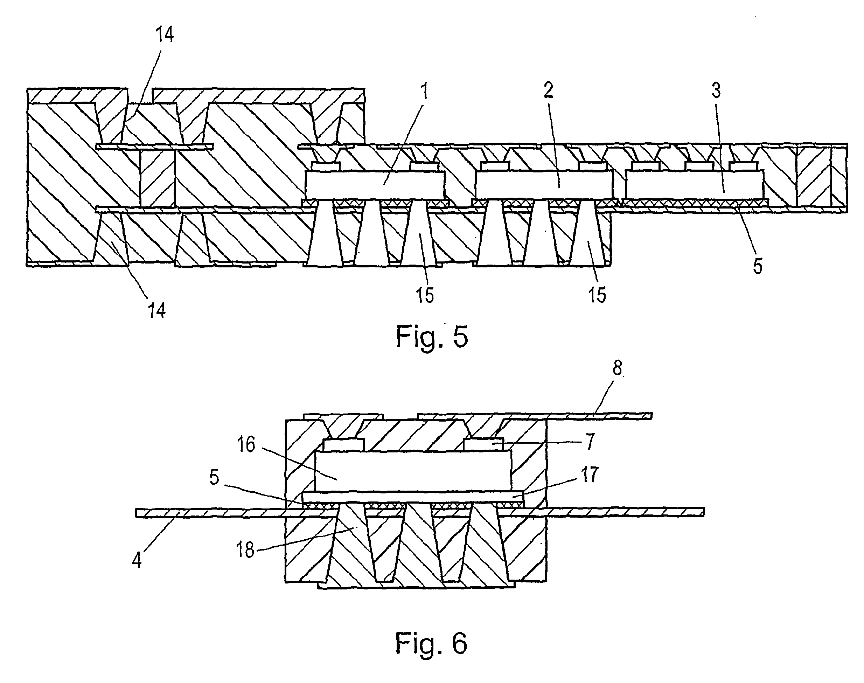

Bei der Darstellung gemäß Fig. 5 ist ersichtlich, daß auch die zusätzlich aufgebrachten Schichten bzw. Lagen 11, 12 und 13 gemäß der Darstellung von Fig. 4 einer weiteren Strukturierung unterworfen werden, wobei beispielsweise wiederum im Bereich von herzustellenden Kontaktierungen Laserbohrungen vorgesehen werden, welche in Fig. 5 beispielsweise mit 14 bezeichnet sind.

Für eine Ableitung von Wärme von den zu integrierenden Bauteilen 1, 2 und 3 sind darüber hinaus in Fig. 5 für die Bauteile 1 und 2 Wärmeableitöffnungen 15 vorgesehen bzw. angedeutet.

Für eine Unterstützung bzw. Verbesserung der Wärmeableitung kann darüber hinaus vorgesehen sein, daß die zur Abstützung der zu integrierenden Bauteile 1, 2 und 3 verwendete Schicht 4 aus einem Metall, beispielsweise ebenfalls aus Kupfer ausgebildet ist, so daß durch die gute Wärmeleitfähigkeit dieses metallischen Materials der Schicht 4 eine entsprechend zuverlässige bzw. verbesserte Abfuhr der insbesondere im Bereich der Bauteile 1 und 2 gegebenenfalls ungleichmäßig entstehenden Wärme in weiterer Folge über die Wärmeableitöffnungen 15 möglich wird.

Zur weiteren Unterstützung des Wärmetransports bzw. einer gleichmäßigeren Verteilung der insbesondere durch die elektronischen Bauteile 1 und 2 erzeugten Wärme kann darüber hinaus vorgesehen sein, daß der zur Festlegung eingesetzte Kleber 5 von einem thermisch leitfähigen Kleber gebildet ist.

Bei der Darstellung gemäß Fig. 6 ist ersichtlich, daß in Abwandlung zu der gemäß den Fig. 1 bis 5 ausgebildeten Leiterplatte, in welcher eine Mehrzahl von Bauteilen 1, 2 und 3 integriert ist, welche jeweils an einer von einer Klebestelle unter Vermittlung eines Klebers 5 abgewandten Seite mit Kontakten bzw. Anschlußstellen 7 versehen sind, der wiederum auf einer mit 4 bezeichneten Schicht über einen Kleber 5 festgelegte, elektronische Bauteil 16 sowohl an der vom Kleber 5 abgewandten Seite mit wiederum mit 7 bezeichneten Kontakten als auch an der zweiten Hauptoberfläche mit einer beispielsweise aus Kupfer gebildeten Unterseite 17 versehen ist, so daß eine Kontaktierung des Bauteils 16 sowohl über die Kontakte 7 als auch die Unterseite 17 erfolgen kann.

Eine derartige Ausbildung erhöht einerseits die Anzahl der Kontaktflächen bzw. -stellen, wobei durch Vorsehen der Kupferschicht 17 an der Unterseite des integrierten, elektronischen Bauteils 16 auch eine verbesserte Wärmeabfuhr über die Kontaktierungsstellen 18 erzielbar ist, welche somit neben einer Kontaktierung auch zur gegebenenfalls verbesserten Ableitung von Wärme herangezogen werden.

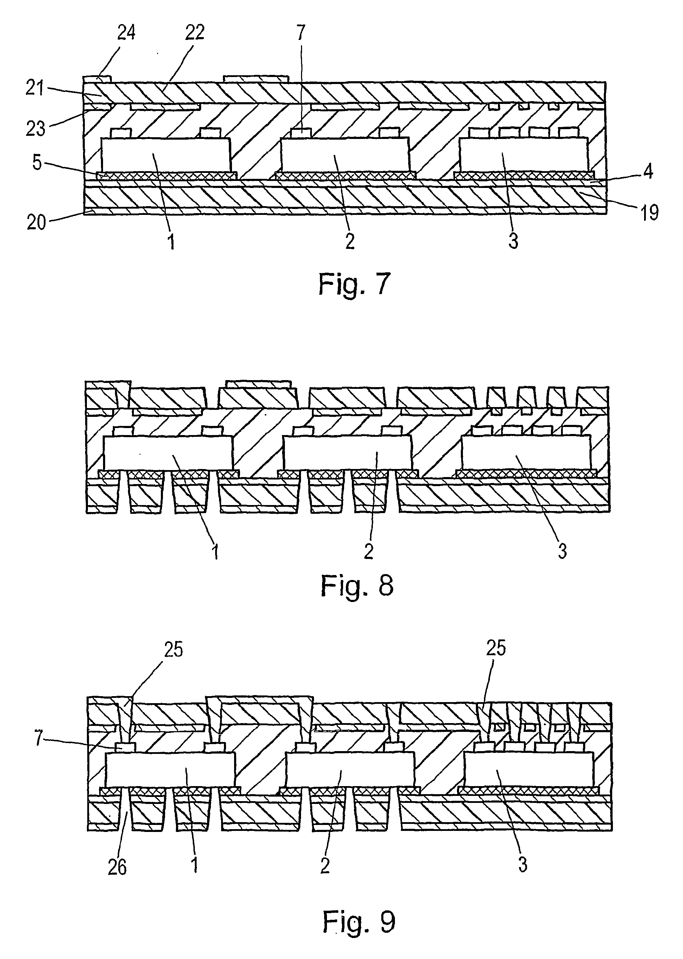

Bei der in Fig. 7 bis 9 dargestellten, abgewandelten Ausführungsform einer herzustellenden Leiterplatte ist ersichtlich, daß wiederum eine Mehrzahl von zu integrierenden Elementen bzw. Bauteilen, welche ähnlich wie bei der Ausführungsform gemäß Fig. 1 bis 5 wiederum mit 1, 2 und 3 bezeichnet sind, über jeweils einen Kleber bzw. eine Klebestelle 5 an einer Schicht 4 festgelegt ist.

Bei der in Fig. 7 dargestellten Ausbildung ist anstelle der Trägerschicht 6 gemäß Fig. 1 nach deren Entfernung bereits ähnlich wie bei der Darstellung gemäß Fig. 4 eine weitere Lage der herzustellenden Leiterplatte angeordnet, wobei diese wiederum beispielsweise von einer RCC-Folie gebildet ist, so daß unter Zwischenschaltung einer isolierenden Schicht 19 eine weitere leitende bzw. leitfähige, insbesondere Kupferschicht 20 vorgesehen ist.

Für eine Kontaktierung der wiederum mit 7 bezeichneten Kontakte bzw. Anschlußstellen der zu integrierenden, elektronischen Bauteile 1, 2 und 3 findet bei der Ausführungsform gemäß Fig. 7 eine mehrlagige Struktur 21 Verwendung, wobei ein vorbearbeiteter, doppelseitiger Kern zum Einsatz gelangt, welcher neben einer isolierenden Zwischenschicht 22 an beiden Seiten mit elektrisch leitenden Schichten bzw. Elementen 23 und 24 versehen ist, deren Strukturierung auf die Positionierung einzelner Anschlußstellen bzw. Kontakte 7 *der* einzubettenden, elektronischen Bauteile 1, 2 und 3 abgestimmt ist.

Für eine Verfüllung von Freiräumen bzw. Zwischenräumen zwischen den einzelnen, zu integrierenden Bauteilen 1, 2 und 3 als auch im Bereich der Kontakte bzw. Anschlußstellen 7 findet wiederum ein isolierendes Material Verwendung, wie dies in Fig. 2 angedeutet ist.

Nach einer Festlegung sowohl des doppelseitigen Kerns 21 als auch der zusätzlichen Schichten bzw. Lagen 19 und 20 findet ähnlich wie bei der Darstellung gemäß Fig. 3 eine Strukturierung beispielsweise durch ein Laserbohren statt, so daß in weiterer Folge, wie dies in Fig. 9 abschließend dargestellt ist, unter Ausbildung von entsprechenden Kontaktierungsstellen 25 eine Kontaktierung der Kontakte 7 der zu integrierenden Bauteile 1, 2 und 3 erfolgt.

Ähnlich wie bei der Ausführungsform gemäß den Fig. 1 bis 5 sind für die Bauteile 1 und 2 wiederum Wärmeableitöffnungen 26 vorgesehen, welche gegebenenfalls mit einem entsprechenden Material verfüllt sein können, welches die Wärmeabfuhr unterstützt.

Anstelle der in den Zeichnungen dargestellten, elektronischen Bauteile 1, 2 und 3, welche beispielsweise von einem P-MOSFET, einem D-MOSFET oder einem IC bzw. einer integrierten Schaltung gebildet sind, kann eine Vielzahl von anderen Komponenten bzw. Bauteilen integriert bzw. angeordnet werden, wobei diese Bauteile aktive oder passive Bauteile und/oder logische Bauteile bzw. Komponenten sein können.

Darüber hinaus ist es neben der in den Figuren schematisch angedeuteten Anordnung von weiteren Schichten bzw. Lagen 11, 12, 13 oder 19 bis 24 zur Herstellung einer insbesondere mehrlagigen Leiterplatte möglich, entsprechend den Anforderungen weitere und zusätzliche Lagen bzw. Schichten vorzusehen, welche entsprechend den herzustellenden Verbindungen strukturiert und miteinander gekoppelt werden können.

Ausgehend von den beispielsweise in Fig. 5, 6 oder 9 dargestellten, im wesentlichen lediglich teilweise fertiggestellten, mehrlagigen Leiterplatten, in welchen die schematisch angedeuteten Bauteile 1, 2 und 3 integriert sind, erfolgt eine weitere Bearbeitung oder Fertigstellung einer derartigen Leiterplatte unter Einsatz bekannter Verarbeitungsschritte bzw. -verfahren.

## Patentansprüche

1. Verfahren zur Integration wenigstens eines elektronischen Bauteils in eine Leiterplatte, umfassend die folgenden Schritte:
- Bereitstellen einer Schicht (4) einer Leiterplatte zur Abstützung des elektronischen Bauteils (1, 2, 3, 16),
- Aufbringen eines Klebers (5) auf eine Oberfläche der Schicht (4),
- Festlegen des elektronischen Bauteils (1, 2, 3, 16) auf der Schicht (4) mittels des Klebers (5),
- Aufbringen bzw. Anordnen wenigstens einer elektrisch leitenden Schicht (8, 23, 24) auf bzw. an dem Bauteil (1, 2, 3, 16) an der vom Kleber (5) abgewandten Seite bzw. Oberfläche, und
- Strukturieren der elektrisch leitenden Schicht (8, 23, 24) entsprechend den Kontakten des elektronischen Bauteils und/oder entsprechend auf der Leiterplatte auszubildenden Leiterbahnen,
**dadurch gekennzeichnet, daß** an der von der elektrisch leitenden Schicht abgewandten Seite des elektronischen Bauteils (1, 2, 3, 16) insbesondere im Bereich der Festlegung des elektronischen Bauteils wenigstens eine Öffnung (15, 18, 26) zur Wärmeableitung und/oder Kontaktierung des Bauteils ausgebildet wird.

2. Verfahren nach Anspruch 1, **dadurch gekennzeichnet, daß** der elektronische Bauteil (1, 2, 3, 16) nach dem Festlegen an der Schicht von einem isolierenden Material (9, 10), insbesondere einer Prepreg-Folie und/oder einem Harz, umgeben wird.

3. Verfahren nach Anspruch 1 oder 2, **dadurch gekennzeichnet, daß** die Schicht (4) zur Abstützung des elektronischen Bauteils (1, 2, 3, 16) auf eine Trägerschicht (6) oder einen Kern vor dem Aufbringen des Klebers (5) aufgebracht wird.

4. Verfahren nach Anspruch 3, **dadurch gekennzeichnet, daß** die Trägerschicht (6) nach dem Festlegen des elektronischen Bauteils (1, 2, 3, 16) entfernt wird.

5. Verfahren nach einem der Ansprüche 1 bis 4, **dadurch gekennzeichnet, daß** der Kleber (5) auf der Oberfläche der Schicht (4) entsprechend einem auf die Anordnung des festzulegenden, elektronischen Bauteils (1, 2, 3, 16) abgestimmten Muster aufgebracht wird.

6. Verfahren nach einem der Ansprüche 1 bis 5, **dadurch gekennzeichnet, daß** die Strukturierung der leitenden Schicht (8, 23, 24) durch eine Laserstrukturierung, eine Fotostrukturierung oder dgl. durchgeführt wird.

7. Verfahren nach einem der Ansprüche 1 bis 6, **dadurch gekennzeichnet, daß** nach einem Strukturieren der leitenden Schicht (8, 23, 24) wenigstens eine isolierende Schicht (11, 22) auf der von dem elektronischen Bauteil (1, 2, 3, 16) abgewandten Oberfläche der strukturierten, leitenden Schicht (8, 23, 24) aufgebracht wird.

8. Verfahren nach einem der Ansprüche 1 bis 7, **dadurch gekennzeichnet, daß** zusätzlich wenigstens eine leitende und/oder nicht leitende Schicht (9, 11, 19, 21), beispielsweise eine RCC-Folie, aufgebracht bzw, angeordnet wird.

9. Verfahren nach einem der Ansprüche 1 bis 8, **dadurch gekennzeichnet, daß** die Schicht (4) zur Abstützung des elektronischen Bauteils (1, 2, 3, 16) von einer metallischen, insbesondere elektrisch leitenden Schicht gebildet wird.

10. Verfahren nach einem der Ansprüche 1 bis 9, **dadurch gekennzeichnet, daß** ein thermisch leitender bzw. leitfähiger Kleber (5) verwendet wird.

11. Verfahren nach einem der Ansprüche 1 bis 10, **dadurch gekennzeichnet, daß** ein elektronisches Bauteil (16) verwendet wird, welches an gegenüberliegenden Hauptoberflächen jeweils mit einer Mehrzahl von Kontakten (7, 17) versehen ist, welche mit den elektrisch leitenden Schichten (4, 8) kontaktiert werden.

12. Verfahren nach einem der Ansprüche 1 bis 11, **dadurch gekennzeichnet, daß** unmittelbar nach dem Strukturieren der elektrisch leitenden Schicht (8, 23, 24) das elektronische Bauteil (1, 2, 3, 16) auf seine Funktionsfähigkeit getestet wird.

13. Leiterplatte mit wenigstens einem integrierten, elektronischen Bauteil, umfassend eine Schicht (4) zur Abstützung des elektronischen Bauteils (1, 2, 3, 16), an welcher das wenigstens eine elektronische Bauteil (1, 2, 3, 16) unter Vermittlung eines Klebers (5) festgelegt ist, wobei wenigstens eine elektrisch leitende Schicht (8, 23, 24) nach Festlegung des elektronischen Bauteils (1, 2, 3, 16) auf bzw, an dem Bauteil (1, 2, 3, 16) angeordnet ist und entsprechend den Kontakten (7) des elektronischen Bauteils (1, 2, 3, 16) und/oder Leiterbahnen der Leiterplatte strukturiert ist, **dadurch gekennzeichnet, daß** an der von der elektrisch leitenden Schicht abgewandten Seite des elektronischen Bauteils (1, 2, 3, 16) Insbesondere im Bereich der Festlegung des elektronischen Bauteils wenigstens eine Öffnung (15, 18, 26) zur Wärmeableitung und/oder Kontaktierung des Bauteils ausgebildet ist.

14. Leiterplatte nach Anspruch 13, **dadurch gekennzeichnet, daß** das elektronische Bauteil (1, 2, 3, 16) von einem isolierendes Material (9, 10), insbesondere einer Prepreg-Folie und/oder einem isolierenden Harz, umgeben ist.

15. Leiterplatte nach Anspruch 13 oder 14, **dadurch gekennzeichnet, daß** zusätzlich eine Mehrzahl von das Bauteil (1, 2, 3, 16) einbettenden Schichten bzw. Lagen (9, 11, 19, 21) aus einem isolierenden und/oder leitenden Material vorgesehen ist.

16. Leiterplatte nach Anspruch 13, 14 oder 15, **dadurch gekennzeichnet, daß** in dem das elektronische Bauteil (1, 2, 3, 16) umgebenden, insbesondere isolierenden Material insbesondere im Bereich der Festlegung des elektronischen Bauteils wenigstens eine Öffnung (15, 18, 26) zur Wärmeableitung vorgesehen ist.

## Claims

1. A method for integrating at least one electronic component into a printed circuit board, comprising the following steps:
- providing a layer (4) of a printed circuit board for supporting the electronic component (1, 2, 3, 16),
- applying an adhesive (5) to a surface of the layer (4),
- fixing the electronic component (1, 2, 3, 16) on the layer (4) by means of the adhesive (5),
- applying or arranging at least one electrically conductive layer (8, 23, 24) on or at the component (1, 2, 3, 16), on the side or surface remote from the adhesive (5), and
- patterning or structuring the electrically conductive layer (8, 23, 24) in accordance with the contacts of the electronic component and/or in accordance with conductor tracks to be formed on the printed circuit board,
**characterized in that**, on the side of the electronic component (1, 2, 3 16) remote from the electrically conductive layer, particularly in the region of fixation of the electronic component, at least one opening (15, 18, 26) is formed for the removal of heat and/or for contacting the component.

2. A method according to claim 1, **characterized in that** the electronic component (1, 2, 3, 16), after having been fixed to the layer, is surrounded by an insulating material (9, 10), in particular a prepreg film and/or a resin.

3. A method according to claim 1 or 2, **characterized in that** the layer (4) for supporting the electronic component (1, 2, 3, 16) is applied on a carrier layer (6) or core prior to applying the adhesive (5).

4. A method according to claim 3, **characterized in that** the carrier layer (6) is removed after the fixation of the electronic component (1, 2, 3, 16).

5. A method according to any one of claims 1 to 4, **characterized in that** the adhesive (5) is applied to the surface of the layer (4) in a pattern matched with the arrangement of the electronic component (1, 2, 3, 16) to be fixed.

6. A method according to any one of claims 1 to 5, **characterized in that** patterning of the conductive layer (8, 23, 24) is performed by laser patterning, photopatterning or the like.

7. A method according to any one of claims 1 to 6, **characterized in that**, after patterning of the conductive layer (8, 23, 24), at least one insulating layer (11, 22) is applied on the surface of the patterned conductive layer (8, 23, 24) remote from the electronic component (1, 2, 3, 16).

8. A method according to any one of claims 1 to 7, **characterized in that** at least one conducting and/or nonconducting layer (9, 11, 19, 21), for instance an RCC foil, is additionally applied or arranged.

9. A method according to any one of claims 1 to 8, **characterized in that** the layer (4) for supporting the electronic component (1, 2, 3, 16) is formed by a metallic and, in particular, electrically conductive layer.

10. A method according to any one of claims 1 to 9, **characterized in that** a thermally conducting or conductive adhesive (5) is used.

11. A method according to any one of claims 1 to 10, **characterized in that** an electronic component (16) is used, which, on opposite main surfaces, is each provided with a plurality of contacts (7, 17) to be contacted with the electrically conductive layers (4, 8).

12. A method according to any one of claims 1 to 11, **characterized in that** the electronic component (1, 2, 3, 16) is tested for its functionality immediately upon patterning of the electrically conductive layer (8, 23, 24).

13. A printed circuit board including at least one integrated electronic component, comprising a layer (4) for supporting the electronic component (1, 2, 3, 16), to which the at least one electronic component (1, 2, 3, 16) is fixed by means of an adhesive (5), wherein, after the fixation of the electronic component (1, 2, 3, 16), at least one electrically conductive layer (8, 23, 24) is arranged on or at the component (1, 2, 3, 16) and patterned in accordance with the contacts (7) of the electronic component (1, 2, 3, 16) and/or conductor tracks or the printed circuit board, **characterized in that**, on the side of the electronic component (1, 2, 3, 16) remote from the electrically conductive layer, particularly in the region of fixation of the electronic component, at least one opening (15, 18, 26) is formed for the removal of heat and/or for contacting the component.

14. A printed circuit board according to claim 13, **characterized in that** the electronic component (1, 2, 3, 16) is surrounded by an insulating material (9, 10), in particular a prepreg film and/or an insulating resin.

15. A printed circuit board according to claim 13 or 14, **characterized in that** a plurality of layers (9, 11, 19, 21) embedding the component (1, 2, 3, 16) and made of insulating and/or conductive materials are provided.

16. A printed circuit board according to claim 13, 14 or 15, **characterized in that** at least one opening (15, 18, 26) for the removal of heat is provided in the particularly insulating material surrounding the electronic component (1, 2, 3, 16), particularly in the region of fixation of the electronic component.

## Revendications

1. Procédé servant à intégrer au moins un composant électronique dans un circuit imprimé, comportant les étapes suivantes consistant à :
- mettre à disposition une couche (4) d'un circuit imprimé servant à soutenir le composant électronique (1, 2, 3, 16),
- appliquer un adhésif (5) sur une surface de la couche (4),
- fixer le composant électronique (1, 2, 3, 16) sur la couche (4) au moyen de l'adhésif (5),
- appliquer ou disposer au moins une couche électroconductrice (8, 23, 24) sur ou au niveau du composant (1, 2, 3, 16) sur un côté ou une surface opposé(e) à l'adhésif (5), et
- structurer la couche électroconductrice (8, 23, 24) de manière à correspondre aux contacts du composant électronique et/ou de manière à correspondre aux pistes conductrices à réaliser sur le circuit imprimé,
**caractérisé en ce qu'**au moins une ouverture (15, 18, 26) servant à dévier la chaleur et/ou à établir un contact avec le composant est réalisée au niveau du côté du composant électronique (1, 2, 3, 16), opposé à la couche électroconductrice, en particulier dans la zone de fixation du composant électronique.

2. Procédé selon la revendication 1, **caractérisé en ce que** le composant électronique (1, 2, 3, 16) est entouré, après la fixation au niveau de la couche, d'un matériau isolant (9, 10), en particulier d'un film préimprégné et/ou d'une résine.

3. Procédé selon la revendication 1 ou 2, **caractérisé en ce que** la couche (4) servant à soutenir le composant électronique (1, 2, 3, 16) est appliquée sur une couche de support (6) ou sur un centre avant l'application de l'adhésif (5).

4. Procédé selon la revendication 3, **caractérisé en ce que** la couche de support (6) est éliminée après la fixation du composant électronique (1, 2, 3, 16).

5. Procédé selon l'une quelconque des revendications 1 à 4, **caractérisé en ce que** l'adhésif (5) est appliqué sur la surface de la couche (4) de manière à s'accorder à un motif coïncidant avec la disposition du composant électronique (1, 2, 3, 16) à fixer.

6. Procédé selon l'une quelconque des revendications 1 à 5, **caractérisé en ce que** la structuration de la couche conductrice (8, 23, 24) est réalisée par une structuration au laser, par une photostructuration ou similaire.

7. Procédé selon l'une quelconque des revendications 1 à 6, **caractérisé en ce qu'**au moins une couche isolante (11, 22) est appliquée sur la surface de la couche conductrice (8, 23, 24) structurée, opposée au composant électronique (1, 2, 3, 16) après une structuration de la couche conductrice (8, 23, 24).

8. Procédé selon l'une quelconque des revendications 1 à 7, **caractérisé en ce qu'**en plus au moins une couche (9, 11, 19, 21) conductrice et/ou non conductrice, par exemple un film RCC, est appliquée ou disposée.

9. Procédé selon l'une quelconque des revendications 1 à 8, **caractérisé en ce que** la couche (4) servant à soutenir le composant électronique (1, 2, 3, 16) est formée par une couche métallique, en particulier une couche électroconductrice.

10. Procédé selon l'une quelconque des revendications 1 à 9, **caractérisé en ce qu'**un adhésif (5) thermiquement conducteur ou conducteur est utilisé.

11. Procédé selon l'une quelconque des revendications 1 à 10, **caractérisé en ce qu'**un composant électronique (16) est utilisé, lequel est pourvu sur des surfaces principales opposées respectivement d'une pluralité de contacts (7, 17), qui sont mis en contact avec les couches électroconductrices (4, 8).

12. Procédé selon l'une quelconque des revendications 1 à 11, **caractérisé en ce que** directement après la structuration de la couche électroconductrice (8, 23, 24), le composant électronique (1, 2, 3, 16) est testé sur sa capacité de fonctionnement.

13. Circuit imprimé équipé d'au moins un composant électronique intégré, comportant une couche (4) servant à soutenir le composant électronique (1, 2, 3, 16), sur laquelle est fixé le composant électronique (1, 2, 3, 16) au moins au nombre de un par l'entremise d'un adhésif (5), sachant qu'au moins une couche électroconductrice (8, 23, 24) est disposée après la fixation du composant électronique (1, 2, 3, 16) sur ou au niveau du composant (1, 2, 3, 16) et est structurée de manière à correspondre aux contacts (7) du composant électronique (1, 2, 3, 16) et/ou à des pistes conductrices du circuit imprimé, **caractérisé en ce qu'**au moins une ouverture (15, 18, 26) servant à dévier la chaleur et/ou à établir un contact avec le composant est réalisée sur le côté du composant électronique (1, 2, 3, 16), opposé à la couche électroconductrice, en particulier dans la zone de la fixation du composant électronique.

14. Circuit imprimé selon la revendication 13, **caractérisé en ce que** le composant électronique (1, 2, 3, 16) est entouré d'un matériau isolant (9, 10), en particulier d'un film préimprégné et/ou d'une résine isolante.

15. Circuit imprimé selon la revendication 13 ou 14, **caractérisé en ce qu'**en outre une pluralité de couches (9, 11, 19, 21) constituées d'un matériau isolant et/ou conducteur, intégrant le composant (1, 2, 3, 16) sont prévues.

16. Circuit imprimé selon la revendication 13, 14, ou 15, **caractérisé en ce qu'**au moins une ouverture (15, 18, 26) servant à dévier la chaleur est prévue dans le matériau entourant, en particulier isolant, le composant électronique (1, 2, 3, 16), en particulier dans la zone de la fixation du composant électronique.
